# DEMANDE DE BREVET EUROPEEN

(11) **EP 1 231 615 A1**
(43) Date de publication de la demande: **14.08.2002**
(21) Numéro de dépôt: 02354029.7
(22) Date de dépôt: 11.02.2002
(51) Int. Cl.: H01F 17/00, H01F 27/36, H01L 23/64

(54) **Structure d'inductance intégrée**

(30) Priorité: 12.02.2001 FR 0101881
(71) Demandeur: STMicroelectronics S.A., 92120 Montrouge (FR)
(72) Inventeur: Lemaire, Frédéric, 38120 Saint Egreve (FR)
(74) Mandataire: de Beaumont, Michel

(57) **Abrégé**

L'invention concerne une structure d'inductance en circuit intégré comprenant un substrat de silicium (2), un enroulement plan d'une piste conductrice (1), une couche résistive (11), non gravée à l'aplomb de l'enroulement, une couche diélectrique (3) entre l'enroulement et ladite couche résistive, et des tronçons conducteurs (12) discontinus, individuellement parallèles à une portion de l'enroulement la plus proche et connectés électriquement à la masse et à ladite couche plus fortement dopée.

## Description

La présente invention concerne le domaine des circuits intégrés et plus particulièrement une inductance formée au-dessus d'un substrat semiconducteur.

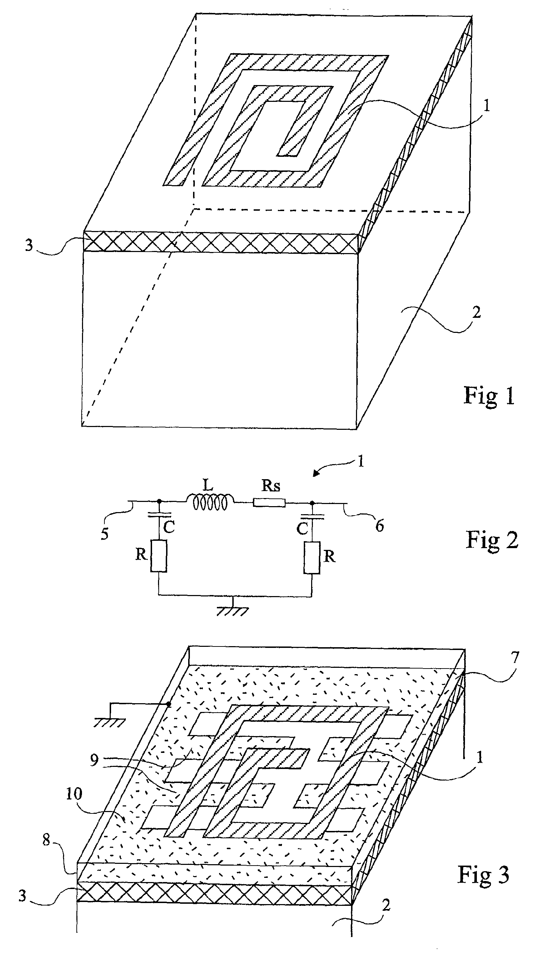

La figure 1 représente, par une vue très schématique en perspective, un premier exemple d'inductance 1 classique formée au-dessus d'un substrat semiconducteur 2. L'inductance 1 comprend un certain nombre de tours ou spires généralement concentriques et obtenus par dépôt d'un élément conducteur sur une couche isolante (diélectrique 3). Le nombre de tours peut également être inférieur à 1. La couche isolante 3, par exemple de l'oxyde de silicium, repose sur le substrat semiconducteur 2, ou sur l'avant dernier niveau de métallisation (non représenté) rapporté sur ce substrat après formation des autres composants qui sont intégrés (par exemple, des transistors et analogues). Le substrat 2 est supposé relié à la masse par sa face inférieure, pour simplifier l'exposé.

La figure 2 représente le schéma électrique équivalent de l'inductance 1 de la figure 1. Cette inductance 1 est symbolisée sous la forme d'une inductance parfaite L en série avec une résistance Rs entre deux bornes 5 et 6 correspondant aux extrémités de l'enroulement de la figure 1. Le diélectrique 3 forme des capacités parasites C entre l'inductance et le substrat. Par ailleurs, le substrat 2 est résistif et il présente des résistances R entre ses faces supérieure et inférieure. Les résistances R relient, à la masse, chaque électrode de condensateur C opposée à l'inductance L.

Un inconvénient d'une inductance telle qu'illustrée en figure 1 est qu'elle présente des pertes élevées. Lorsque l'inductance est parcourue par un courant variable, ces pertes se produisent par l'intermédiaire de la résistance Rs, des capacités C et des résistances R et ont l'inconvénient de diminuer fortement le coefficient de qualité de l'inductance. Ce coefficient de qualité dépend des pertes résistives à savoir de la résistance série Rs et de la résistance apportée par le substrat jusqu'à la connexion de masse.

Une première solution pour accroître le facteur de qualité de l'inductance est de minimiser sa résistance série Rs. Pour ce faire, on est conduit à augmenter la largeur de la piste conductrice constitutive de l'inductance plane 1. Cela a pour conséquence d'augmenter la valeur des capacités parasites du diélectrique 3 et, par conséquent, les pertes résistives par le substrat. On est alors conduit à un compromis en fonction de la fréquence de travail à laquelle est destinée l'inductance.

Une autre solution connue pour accroître le facteur de qualité est décrite dans la demande de brevet européen EP-A-0 780 853. Il y est proposé une structure d'inductance sur un substrat de silicium comportant un plan conducteur situé entre l'inductance et le substrat. Ce plan conducteur, isolé du substrat et de l'inductance, est relié à la masse ou à un point froid du circuit, afin d'établir un "blindage" ou "écran électrostatique" entre l'inductance et le substrat semiconducteur. Pour éviter une dissipation par création de courants de Foucault dans le plan conducteur, ladite demande propose un découpage de ce plan conducteur.

Un type d'inductance avec un plan conducteur découpé selon un exemple de la demande ci-dessus mentionnée est illustré en figure 3.

La figure 3 représente, par une vue en perspective schématique, une inductance 1 formée, comme précédemment, d'une ou plusieurs spires coplanaires en un matériau conducteur. L'inductance 1 est séparée d'un plan conducteur 7 par une couche isolante 8. Le plan conducteur 7 est lui-même déposé sur une couche isolante (diélectrique 3) reposant sur le substrat 2 ou sur un niveau de métallisation. Le plan conducteur 7 est découpé en bandes longitudinales 9 reliées à une bande latérale 10. Dans l'exemple illustré par la figure 3, des bandes longitudinales 9 se trouvent de part et d'autre de l'inductance 1 en étant reliées à des bandes latérales d'extrémité du plan conducteur 7. L'ensemble des éléments conducteurs subsistant du plan 7 sont connectés à la masse. L'effet dû aux courants de Foucault est ainsi fortement diminué, mais la structure de la figure 3 présente des inconvénients.

Un premier inconvénient est que, pour une épaisseur globale d'isolant au-dessus du substrat 2, l'épaisseur de diélectrique disponible entre l'inductance et le plan conducteur est réduite par rapport au cas de la figure 1.

En effet, le plan conducteur est :
soit une couche métallique ou une couche de silicium polycristallin venant s'intercaler entre l'inductance et le substrat, donc réduisant l'épaisseur du diélectrique et augmentant les capacités parasites entre l'inductance et le substrat ou entre l'inductance et la couche conductrice si celle-ci est mise à la masse ;
soit une couche très fortement dopée, diffusée dans le silicium et dont la réalisation nécessite une gravure de diélectrique (de l'oxyde épais (LOCOS) séparant les composants actifs les uns des autres), donc en définitive une épaisseur de diélectrique plus faible entre l'inductance et cette couche diffusée.

Il en découle une augmentation des capacités parasites entre l'inductance et la masse alors que l'on cherche généralement à minimiser la valeur de la capacité parasite.

Un autre inconvénient de la structure proposée en figure 3 est que, lorsque l'inductance 1 est parcourue par un courant variable, chacune des bandes 9 est le siège d'une force électromotrice due au couplage inductif existant entre les bandes et l'inductance. De même, la bande latérale 10 est le siège d'une force électromotrice due au couplage inductif entre cette bande latérale et l'inductance 1. Ces forces électromotrices provoquent des pertes. En effet, chacun des points des bandes 9 et 10 se trouve à un potentiel non nul par rapport à la masse en raison des forces électromotrices induites, et, de ce fait, des pertes se produisent par l'intermédiaire d'une capacité due à la couche 8 servant de diélectrique et de la résistance ohmique du substrat. Ces capacités et résistances ohmiques sont des grandeurs réparties et différentes en chaque point du plan conducteur 7.

Toutes ces pertes rendent le comportement de la structure de la figure 3 insatisfaisant et abaissent le coefficient de qualité Q de l'inductance.

On notera que, pour que la solution proposée par la demande de brevet européen susmentionnée procure un résultat, il est nécessaire que les bandes du plan conducteur soient majoritairement situées sous la piste conductrice constitutive de l'inductance 1.

La demande de brevet susmentionnée propose d'autres manières de découper le plan conducteur (voir les figures 7, 9 et 12 de cette demande). Cependant, dans tous les exemples proposés de ladite demande, l'inductance est majoritairement sur des bandes conductrices et il demeure des portions de plan conducteur dans lesquelles une force électromotrice induite élevée provoque l'effet indésirable qui a été décrit.

La présente invention vise à proposer une nouvelle structure d'inductance en circuit intégré qui pallie les inconvénients des structures connues.

L'invention vise, plus particulièrement à proposer une solution qui combine les avantages d'une capacité parasite faible et d'une faible résistance ohmique d'accès à la masse.

L'invention vise également à proposer une solution qui minimise les pertes liées au fonctionnement de l'inductance et, en particulier, qui minimise d'éventuelles forces électromotrices induites.

Pour atteindre ces objets ainsi que d'autres, la présente invention prévoit une structure d'inductance en circuit intégré comprenant un substrat de silicium, au moins un enroulement plan d'une piste conductrice, une couche résistive, non gravée à l'aplomb de l'enroulement, une couche diélectrique entre l'enroulement et ladite couche résistive, et des tronçons conducteurs discontinus, individuellement parallèles à une portion de l'enroulement la plus proche et connectés électriquement à la masse et à ladite couche résistive.

Selon un mode de réalisation de la présente invention, lesdits tronçons conducteurs sont majoritairement hors de l'aplomb de l'enroulement.

Selon un mode de réalisation de la présente invention, chaque tronçon conducteur est placé le plus près possible de la portion de l'enroulement la plus proche.

Selon un mode de réalisation de la présente invention, chaque portion de l'enroulement est associée, dans sa longueur, à plusieurs tronçons conducteurs.

Selon un mode de réalisation de la présente invention, lesdits tronçons conducteurs sont reliés à un point de contact par plusieurs pistes conductrices, chacune des pistes conductrices étant disposée de sorte que la résultante des forces électromotrices qui sont induites par l'inductance soit sensiblement nulle.

Selon un mode de réalisation de la présente invention, chacune des pistes conductrices est plus sensiblement un axe de symétrie de l'inductance.

Selon un mode de réalisation de la présente invention, lesdits tronçons conducteurs sont réalisés dans un même niveau métallique que la piste formant inductance.

Selon un mode de réalisation de la présente invention, ladite couche résistive a un niveau de dopage compris entre 10¹⁶ et 10¹⁹ atomes/cm³, de préférence, de l'ordre de 10¹⁷ atomes/cm³.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, décrite précédemment, représente une inductance déposée sur un substrat conducteur selon l'art antérieur ;
la figure 2, décrite précédemment, représente le schéma électrique équivalent de l'inductance représentée en figure 1 ;
la figure 3, décrite précédemment, représente une autre structure d'inductance déposée sur un substrat semiconducteur selon l'art antérieur ;
la figure 4 représente, par une vue en perspective schématique, une structure d'inductance selon un mode de réalisation de la présente invention ;
la figure 5 est une vue partielle en coupe de l'inductance représentée en figure 4 ;
la figure 6 représente le schéma électrique équivalent de la structure d'inductance de la figure 4 ; et
la figure 7 représente, par une vue de dessus, une structure d'inductance selon un mode de réalisation préféré de la présente invention.

Une caractéristique de la présente invention est de supprimer le recours à un plan conducteur sous l'inductance 1. Plus précisément, l'invention prévoit d'utiliser un niveau résistif pour constituer l'armature inférieure de la capacité parasite de l'inductance, connectée à la masse. Selon l'invention, cette connexion de masse s'effectue au moyen de pistes conductrices associées au niveau résistif et qui ont la caractéristique d'être majoritairement situées hors de l'aplomb de l'inductance 1.

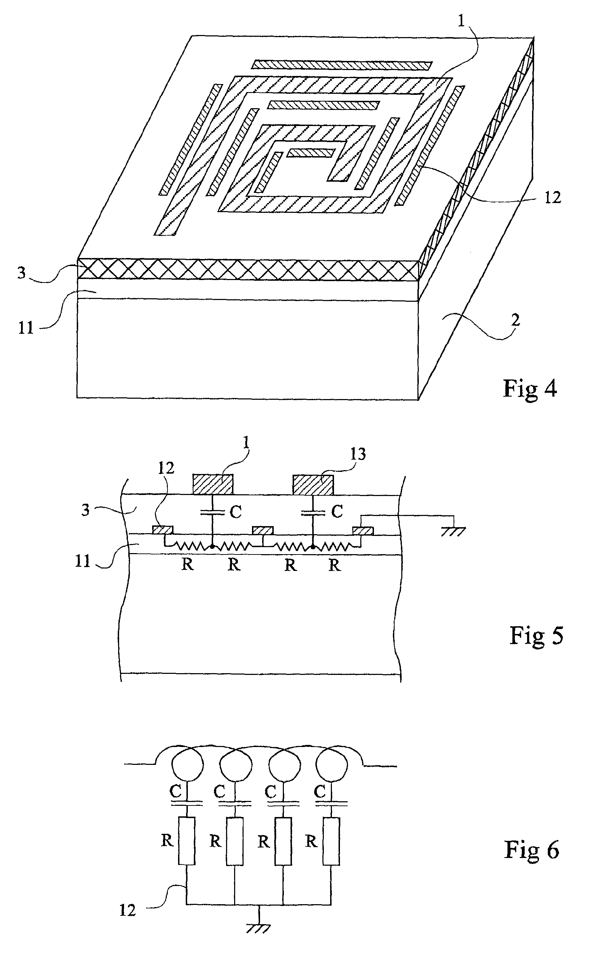

La figure 4 représente, par une vue schématique en perspective, un mode de réalisation d'une structure d'inductance selon la présente invention.

Comme précédemment, l'inductance 1 est constituée à partir d'une piste conductrice déposée sous la forme d'un enroulement plan sur une couche isolante 3. La structure de l'invention reprend ici la structure du cas classique de la figure 1.

Une caractéristique de la présente invention est de prévoir, sous la couche diélectrique 3, une couche semiconductrice 11 moyennement dopée et, généralement, plus fortement dopée que le substrat 2 de silicium sur lequel elle repose. L'invention tire ici profit de la présence, dans une structure de circuit intégré, d'une couche plus fortement dopée que le substrat. Il s'agit généralement d'une couche épitaxiée dans laquelle sont réalisées des régions fortement dopées servant à former les sources et drains de transistors MOS, les émetteurs de transistors bipolaires, des puits de collecteurs de transistors NPN (sinker).

L'épaisseur de diélectrique entre cette couche 11 et l'inductance est maximale. La capacité parasite de l'inductance est donc plus faible que si l'on utilisait une couche intermédiaire, en métal ou en silicium polycristallin, ou une couche diffusée très fortement dopée, qui nécessite une gravure d'oxyde épais (LOCOS).

La figure 5 est une vue partielle en coupe d'une structure d'inductance selon l'invention et la figure 6 représente le schéma électrique équivalent d'une telle structure. Ce schéma équivalent se déduit de l'exposé de la figure 4 et de la figure 5 dans laquelle des éléments capacitifs et résistifs ont également été symbolisés.

De façon classique, la couche diélectrique 3 introduit des éléments capacitifs C sous les tronçons 13 de spire de l'inductance 1. Ces éléments capacitifs relient chaque tronçon de spire à la couche 11. La couche 11 est reliée à la masse de façon discontinue au moyen de tronçons 12 disposés parallèlement aux tronçons de l'inductance 1 en étant à l'extérieur de l'aplomb de la spire. Par conséquent, la couche 11 introduit des résistances R latérales entre chaque tronçon 13 de spire et un élément 12 de connexion à la masse. Les différentes résistances latérales se trouvent associées en parallèle comme l'illustre la figure 6. Par conséquent, la résistivité de la couche 11 liée à son dopage doit être suffisamment faible pour être négligeable dans l'association en parallèle des résistances latérales par rapport à la résistance verticale du substrat. Toutefois, le compromis à effectuer est que, pour éviter l'apparition de courants de Foucault, cette résistance R doit être suffisamment élevée dans la mesure où la couche 11 est continue.

Selon l'invention, la couche 11 est choisie pour avoir un dopage supérieur à 10¹⁵ atomes/cm³ correspondant au dopage du substrat en technologie BiCMOS, et inférieur à 10²⁰ correspondant au dopage des puits collecteurs NPN ainsi que des sources et drains de transistors MOS ou des émetteurs de transistors NPN. De préférence, la couche 11 a un niveau de dopage compris entre 10¹⁶ et 10¹⁹ atomes/cm³, de préférence, de l'ordre de 10¹⁷ atomes/cm³. Généralement, la couche épitaxiée, ou les caissons N ou P (dans lesquels sont formés les transistors MOS élémentaires) réalisés sans gravure de l'oxyde épais, que prévoit d'utiliser la présente invention ont un dopage de l'ordre de 10¹⁶ à 10¹⁷ atomes/cm³.

Une autre caractéristique de la présente invention est que les tronçons conducteurs 12 ayant pour fonction de connecter les résistances latérales à la masse sont disposés majoritairement à l'extérieur de l'aplomb de l'inductance 1, afin de ne pas augmenter sa capacité parasite. Il est toutefois possible de prévoir des tronçons 12 sous les tronçons de l'inductance.

Comme l'illustre la figure 4, ces tronçons conducteurs 12 sont préférentiellement étroits par rapport aux tronçons 13 constitutifs de l'inductance 1.

Un avantage de la présente invention est qu'elle tire profit de l'existence d'une couche épitaxiée dans les structures de circuit intégré prévoyant une inductance.

Un autre avantage de l'invention est qu'elle évite le recours à un niveau conducteur découpé à l'aplomb des spires de l'inductance 1. Ainsi, l'invention permet de maintenir une épaisseur de diélectrique 3 relativement élevée pour une épaisseur donnée de l'empilement multicouches du circuit intégré.

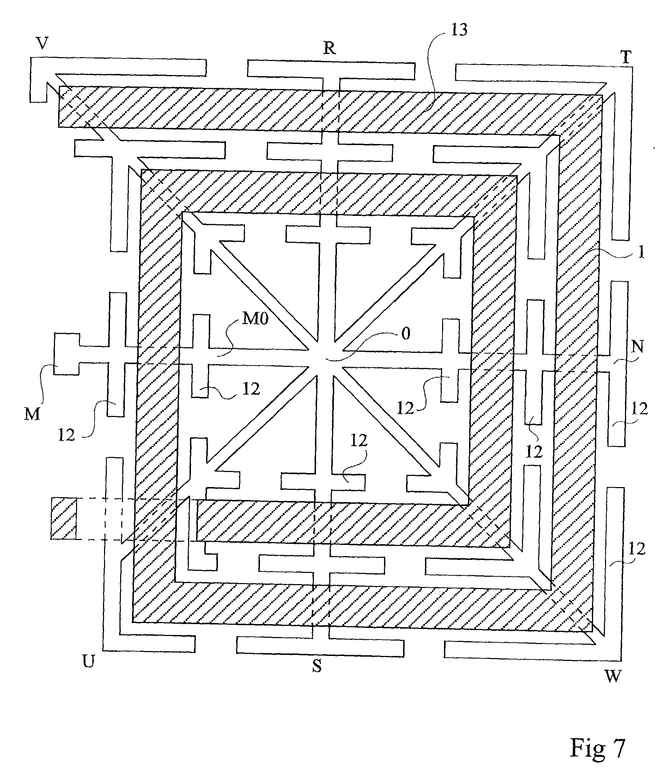

La figure 7 représente, par une vue schématique de dessus, un mode de réalisation de la présente invention illustrant plus particulièrement un mode préféré de raccordement à la masse des tronçons 12 discontinus prévus parallèlement aux tronçons 13 de la spire 1.

Dans ce mode de réalisation, la longueur des tronçons conducteurs 12 ne s'étend pas de part et d'autre de la portion 13 rectiligne de spire considérée. Ces tronçons conducteurs 12 sont préférentiellement répartis au nombre de trois par portion rectiligne 13 de spire. Un point de contact M destiné à être raccordé à la masse est relié à un point O correspondant au centre de l'inductance 1 par une piste conductrice MO qui connecte au point M les tronçons conducteurs 12 qu'elle croise. Diverses autres pistes conductrices passent par le point O et relient un petit nombre de tronçons conducteurs 12. Ainsi, le prolongement de la piste MO, la piste ON, relie trois éléments 12. Une piste ROS perpendiculaire à la piste MON relie d'autres tronçons. De façon similaire, des pistes VOW et TOU, en diagonale sur la figure 7, relient les tronçons conducteurs restants, qui encadrent les sommets de l'inductance 1.

De préférence, ces pistes conductrices ont une largeur minimum, compatible avec la résistance maximum tolérable qu'elles peuvent présenter.

On notera que les pistes d'interconnexion à la masse et les tronçons encadrant les portions de spire ne se limitent pas à des segments rectilignes mais sont disposés de façon à relier efficacement les tronçons 12.

On notera également que le point O est commun à toutes les pistes d'interconnexion qui, du fait de la piste OM, se trouvent toutes reliées électriquement au point de contact de masse M. En pratique, la piste OM est plus large que les autres pistes afin de pouvoir drainer efficacement, si besoin est, des courants résiduels vers l'extérieur de la spire.

La disposition des pistes conductrices reliant les tronçons 12 a été choisie de sorte que la résultante des forces électromotrices induites dans les pistes conductrices soit sensiblement nulle. Le fait que les tronçons conducteurs 12 soient de petite taille résout pratiquement le problème des courants de Foucault. Seul reste à envisager le problème dû aux forces électromotrices induites.

De façon générale, la force électromotrice induite, dans un premier conducteur, par un second conducteur parcouru par un courant variable i, a pour valeur e = -M.di/dt, M étant le coefficient d'inductance mutuel entre les deux conducteurs et di/dt la variation en fonction du temps du courant i parcourant le second conducteur.

Pour deux conducteurs rectilignes parallèles, le coefficient d'inductance mutuel est fonction de la longueur des conducteurs et de la distance qui les sépare, M étant d'autant plus élevé que la longueur des conducteurs est grande et que leur distance est faible. Si les conducteurs ne sont pas parallèles mais forment un certain angle, leur coefficient d'inductance mutuel est proportionnel au cosinus de l'angle formé par les deux conducteurs. Enfin, lorsque deux conducteurs sont perpendiculaires (leur angle est de 90°), leur coefficient d'inductance mutuel est nul.

Ainsi, pour réduire les forces électromotrices induites dans les pistes conductrices et, par suite, les pertes subies par l'inductance 1, on réalise autant que possible trois types de configuration.

Selon une première configuration, une piste d'interconnexion conductrice (MON, ROS) est perpendiculaire aux tronçons 13 de spire qu'elle traverse d'où il résulte une inductance mutuelle nulle et une force électromotrice induite nulle également.

Selon une deuxième configuration, chaque piste d'interconnexion est parallèle à au moins deux tronçons 13 de spire et à égale distance entre celles-ci. Cela revient à placer ces pistes au centre de chaque portion rectiligne 13 de spire et aux angles. Comme chaque spire de l'inductance comporte des portions parcourues par un courant de même valeur absolue et de sens inverse, les pistes conductrices présentent une inductance mutuelle avec les spires 13 formée de deux composantes, une positive et l'autre négative. Ces composantes se retranchent et s'annulent exactement si le nombre de portions de spire est le même de chaque côté.

Selon une troisième configuration, utilisée pour les sommets de l'inductance, une piste d'interconnexion est disposée suivant la bissectrice de l'angle formé par les portions de spire. Ces portions étant parcourues par des courants de sens opposé (respectivement se dirigeant et s'éloignant du sommet de l'angle qu'elle forme), l'inductance mutuelle résultant d'entre ces portions de spire et la piste ou le tronçon de piste considéré est également nulle ainsi que la force électromotrice résultante induite dans la piste ou le tronçon de piste considéré.

Ainsi, il apparaît que, grâce à la structure selon la présente invention, les résultantes des forces électromotrices induites dans les diverses pistes conductrices de connexion à la masse du plan plus fortement dopé que le substrat sont nulles ou avoisinent zéro. En fait, si l'inductance était parfaitement symétrique, la structure décrite ci-dessus permettrait une parfaite compensation des forces électromotrices induites dans les pistes conductrices MON, ROS, TOU, VOW.

Bien entendu, la structure d'inductance illustrée en figure 7 n'est qu'un exemple seulement de la présente invention et est susceptible de diverses variantes et modifications qui apparaîtront à l'homme de l'art. En particulier, l'exemple des figures présente une inductance carrée. Il va bien entendu de soi que la présente invention peut être appliquée quel que soit le nombre de spires de l'inductance et quelle que soit la forme de l'inductance, pourvu de respecter le recours à une couche semiconductrice plus fortement dopée que le substrat et à des tronçons conducteurs 12 de raccordement discontinus de cette couche à la masse, ces tronçons étant préférentiellement majoritairement hors de l'aplomb de l'enroulement.

De plus, si les spires de l'inductance sont circulaires ou en spirale et présentent un centre, on peut conserver une forme rectangulaire aux tronçons conducteurs 12. Ceux-ci auront toutefois une forme trapézoïdale limitée par des rayons de centre correspondant au centre de la spire ou soit seront des parties de secteurs circulaires ayant pour centre le centre de la spire. Quoi qu'il en soit, ces éléments seront disposés radialement et leur connexion au centre se fera par des pistes conductrices disposées aussi radialement, une telle structure parfaitement symétrique présentant des pertes minimales.

En outre, bien que les tronçons conducteurs 12 aient été représentés sur la couche 11, les connexions à la masse de la couche 11 pourront être réalisées par des tronçons sous-jacents. De même, les pistes d'interconnexion des tronçons 12 seront formées dans un niveau adapté, dont le choix est à la portée de l'homme du métier.

Enfin, bien que l'invention ait été décrite en relation avec une inductance dans un seul plan, celle-ci pourra être réalisée dans plusieurs niveaux conducteurs associés en série ou en parallèle.

## Revendications

1. Structure d'inductance en circuit intégré comprenant :
un substrat de silicium (2) ;
au moins un enroulement plan d'une piste conductrice (1) ;
une couche résistive (11), non gravée à l'aplomb de l'enroulement ;
une couche diélectrique (3) entre l'enroulement et ladite couche résistive ; et
des tronçons conducteurs (12) discontinus, individuellement parallèles à une portion de l'enroulement la plus proche et connectés électriquement à la masse et à ladite couche résistive.

2. Structure selon la revendication 1, **caractérisée en ce que** lesdits tronçons conducteurs (12) sont majoritairement hors de l'aplomb de l'enroulement (1).

3. Structure selon la revendication 1 ou 2, **caractérisée en ce que** chaque tronçon conducteur est placé le plus près possible de la portion (13) de l'enroulement (1) la plus proche.

4. Structure selon l'une quelconque des revendications 1 à 3, **caractérisée en ce que** chaque portion (13) de l'enroulement est associée, dans sa longueur, à plusieurs tronçons conducteurs (12).

5. Structure d'inductance selon l'une quelconque des revendications 1 à 4, **caractérisée en ce que** lesdits tronçons conducteurs (12) sont reliés à un point de contact (M) par plusieurs pistes conductrices, chacune des pistes conductrices étant disposée de sorte que la résultante des forces électromotrices qui sont induites par l'inductance soit sensiblement nulle.

6. Structure selon la revendication 5, dans laquelle chacune des pistes conductrices est plus sensiblement un axe de symétrie de l'inductance (1).

7. Structure selon l'une quelconque des revendications 1 à 6, **caractérisée en ce que** lesdits tronçons conducteurs (12) sont réalisés dans un même niveau métallique que la piste (1) formant inductance.

8. Structure d'inductance selon l'une quelconque des revendications 1 à 7, **caractérisée en ce que** ladite couche résistive (11) a un niveau de dopage compris entre 10¹⁶ et 10¹⁹ atomes/cm³, de préférence, de l'ordre de 10¹⁷ atomes/cm³.
